# EUROPÄISCHE PATENTSCHRIFT

(11) **EP 2 361 441 B1**
(45) Veröffentlichungstag und Bekanntmachung des Hinweises auf die Patenterteilung: **02.04.2014**
(21) Anmeldenummer: 09760719.6
(22) Anmeldetag: 04.11.2009
(51) Int. Cl.: H01L 35/30, H01L 35/32, F01N 5/02

(54) **MODUL FÜR EINEM THERMOELEKTRISCHEN GENERATOR UND EIN THERMOELEKTRISCHER GENERATOR**
MODULE FOR A THERMOELECTRIC GENERATOR AND A THERMOELECTRIC GENERATOR
MODULE POUR GÉNÉRATEUR THERMOÉLECTRIQUE ET GÉNÉRATEUR THERMOÉLECTRIQUE

(30) Priorität: 24.11.2008 DE 102008058779
(43) Veröffentlichungstag der Anmeldung: 31.08.2011
(73) Patentinhaber: Emitec Gesellschaft für Emissionstechnologie mbH, 53797 Lohmar (DE)
(72) Erfinder: LIMBECK, Sigrid, 53804 Much (DE); BRÜCK, Rolf, 51429 Bergisch Gladbach (DE)
(74) Vertreter: Rössler, Matthias
(86) Internationale Anmeldenummer: PCT/EP2009/007897
(87) Internationale Veröffentlichungsnummer: WO 2010/057578

(56) Entgegenhaltungen:
- EP-A1- 1 780 807
- GB-A- 874 660
- JP-A- 9 036 439
- JP-A- 9 199 764
- JP-A- 11 036 981
- US-A- 3 054 840
- US-A- 3 197 342
- US-A- 3 243 869
- US-A- 3 269 872
- US-A- 4 095 998
- US-A- 6 096 966

## Beschreibung

Die vorliegende Erfindung betrifft einen thermoelektrischen Generator zur Erzeugung elektrischer Energie aus der Wärmedifferenz eines Fluids und eines Kühlmittels, wobei das Fluid insbesondere das Abgas einer Verbrennungskraftmaschine eines Kraftfahrzeuges ist.

Das Abgas aus einer Verbrennungskraftmaschine eines Kraftfahrzeuges besitzt thermische Energie, welche mittels des thermoelektrischen Generators in elektrische Energie umgewandelt werden soll, um beispielsweise eine Batterie oder einen anderen Energiespeicher zu füllen und/oder elektrischen Verbrauchern die benötigte Energie direkt zuzuführen, Damit steht für den Betrieb des Kraftfahrzeuges Energie in größerem Umfang zur Verfügung.

Ein solcher thermoelektrischer Generator weist zumeist eine Mehrzahl, gegebenenfalls modulartiger, thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des Seebeck-Effekts und ein Phänomen, welches mit Wärmeadsorbtion einhergeht und in Relation zu einem Stromfluss durch unterschiedliche Materialien verursacht wird. Der Peltier-Effekt ist beispielsweise zum thermoelektrischen Kühlen bereits vorgeschlagen worden.

Solche thermoelektrischen Wandlerelemente weisen bevorzugt eine Vielzahl von thermoelektrischen Elementen auf, die zwischen einer so genannten "Warmseite" und einer so genannten "Kaltseite" positioniert sind. Thermoelektrische Elemente umfassen z. B. wenigstens 2 Halbleiterquader (p- und n-dotiert), die auf ihrer Ober- und Unterseite (hin zur "heißen Seite" beziehungsweise "kalten Seite") wechselseitig mit elektrisch leitenden Brücken verbunden sind. Keramikplatten, beziehungsweise Keramikbeschichtungen und/oder ähnliche Materialien, dienen zur Isolierung der Metallbrücken und sind somit bevorzugt zwischen den Metallbrücken angeordnet. Wird ein Temperaturgefälle beidseits der Halbleiterquader bereit gestellt, so bildet sich ein Spannungspotential. Auf der einen Kontaktstelle wird dabei Wärme aufgenommen ("Warmseite"), wobei die Elektronen der einen Seite auf das energetisch höher liegende Leitungsband des folgenden Quaders gelangen. Auf der anderen Seite können die Elektronen nun Energie freisetzen, um wieder auf die andere Seite mit niedrigerem Energieniveau zu gelangen ("Kaltseite"). Somit kann sich bei einem entsprechenden Temperaturgefälle ein Stromfluss einstellen.

US 3 054 840 A (ALSING CARL F) offenbart einen zylindrischen thermoelektrischen Generator, bei dem ringförmige Halbleiterelemente an Scheibenelementen befestigt sind. Diese Scheibenelemente weisen einen zum Halbleiterelement beabstandeten Flansch auf, mit dem sie entweder an einem ausseren zylindrischen Rohr oder inneren zylindrischen Rohr befestigt sind. Der Wärmeübergang innerhalb des thermoelektrischen Generators erfolgt von innen oder von aussen über das jeweilige Rohr auf den dort angebundenen zylindrisch geformten Flansch. Über den Flansch wird die Wärme an das Halbleiterelement in Richtung der Achse des Zylinders abgegeben und weiter über das nächste Scheibenelement entweder zum äusseren Rohr oder zum inneren Rohr abgeführt. Entsprechend dienen die Scheibenelemente in erster Linie der Wärmeleitung. Die Flansche sind zwar elektrisch leitend ausgeführt, die Stromleitung erfolgt allerdings nur über die Kontaktflache der ringförmigen Halbleiterelemente in axialer Richtung des Generators.

Es ist bereits versucht worden entsprechende thermoelektrische Generatoren, insbesondere für die Anwendung in Kraftfahrzeugen, bereitzustellen. Diese waren jedoch meist sehr teuer in der Herstellung und gekennzeichnet durch eine relativ große Baugröße. Damit konnte noch keine Serientauglichkeit erlangt werden.

Aufgabe der vorliegenden Erfindung ist es demnach, die mit Bezug auf den Stand der Technik geschilderten Probleme zumindest teilweise zu lösen. Insbesondere sollen, ein elektrischer Leiter und ein thermoelektrischer Generator angegeben werden, die einzeln oder zusammengenommen einen thermoelektrischen Generator darstellen, der hinsichtlich seiner Baugröße soweit an andere Bauteile insbesondere eines Kraftfahrzeuges angepasst ist, dass er in vielfältiger Weise in Kraftfahrzeugen eingesetzt werden kann. Weiter sollen diese Komponenten in ein bestehendes Fahrzeugkonzept ohne weitreichende Änderungen einbaubar und insbesondere gegen bereits vorhandene Komponenten austauschbar verbaubar sein. Darüber hinaus sollen auch die bestehenden Probleme hinsichtlich der Trennung von Fluid und Kühlmittel bei einem solchen thermoelektrischen Generator und die elektrische Kontaktierung so gelöst werden, dass ein einfacher, robuster und dauerhafter Einsatz des thermoelektrischen Generators mit geringer Verlustleistung ermöglicht ist. Auch soll ein geeignetes Herstellungsverfahren für die Wandlerelemente, beziehungsweise den thermoelektrischen Generator, angegeben werden.

Diese Aufgaben werden mit einem elektrischen Leiter gemäß den Merkmalen des Patentanspruchs 1, mit einem thermoelektrischen Generator gemäß den Merkmalen des Patentanspruchs 2 sowie Herstellungsverfahren mit den Merkmalen des Patentanspruchs 8 und 10 gelöst. Vorteilhafte Ausgestaltungen der erfindungsgemäßen Vorrichtungen sind in den jeweils abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und fuhrt ergänzende Ausführungsbeispiele der Erfindung an.

Das Modul für einen thermoelektrischen Generator ist mit einem ersten Ende und einem zweiten Ende ausgeführt. Das Modul weist weiter zumindest ein inneres Rohr und ein außen um das innere Rohr herum angeordnetes äußeren Rohr sowie zumindest ein thermoelektrisches Element auf, das zwischen innerem Rohr und äußerem Rohr angeordnet ist, wobei das innere Rohr und das äußeres Rohr jeweils elektrisch isoliert sind gegenüber dem zumindest einen thermoelektrischen Element. Weiter ist jeweils zumindest ein elektrisch leitender erster Kontakt an dem ersten Ende und an dem zweiten Ende vorgesehen, welcher zur elektrisch leitenden Verbindung des zumindest einen thermoelektrischen Elements mit einem elektrischen Leiter dient. Das Modul ist zudem von dem ersten Ende zu dem zweiten Ende für ein Fluid oder ein Kühlmittel durchströmbar.

Das Modul ist hier insbesondere länglich oder rohrähnlich aufgebaut und bildet innen einen durchströmbaren Querschnitt für das Fluid oder das Kühlmittel. Um diesen - vom inneren Rohr gebildeten - Strömungskanal herum sind nun die thermoelektrischen Elemente angeordnet, die wiederum über das äußere Rohr mit dem darum strömenden Kühlmittel oder Fluid wärmetechnisch in Kontakt stehen können. Dabei ist das innere Rohr und das äußere Rohr bevorzugt metallisch und hat insbesondere einen im Wesentlichen gleichartigen Querschnitt, der z. B. rund oder mehreckig ausgeführt ist. Das Modul hat bevorzugt eine Länge von zumindest 15 bis 40 cm [Zentimeter] und weist insbesondere einen inneren Durchmesser des inneren Rohres von 2 mm bis 15 mm [Millimeter] auf. Das das innere Rohr umgebende äußere Rohr weist einen möglichst geringen Außendurchmesser auf, so dass das Modul insgesamt nur wenig Bauraum benötigt.

Das zumindest eine thermoelektrische Element ist derart zwischen innerem Rohr und äußeren Rohr angeordnet, dass bei Beaufschlagen des Moduls mit einem Kühlmittel und einem wärmeren Fluid eine Temperaturdifferenz zwischen äußerem Rohr und innerem Rohr existent ist, so dass durch das thermoelektrische Element ein Siromfluss generiert wird. Die so erzeugbare Strommenge ist insbesondere abhängig von der Art des thermoelektnschen Elementes, also insbesondere den Wirkungsgrad des thermoelektrischen Elementes bei einer bestimmten Temperatur, sowie von den vorherrschenden Temperaturen an der "Warmseite" des Moduls und der "Kaltseite" des Moduls. Regelmäßig werden mehrere oder sogar eine Vielzahl thermoelektrische Elemente zwischen den beiden Rohren platziert.

Weiterhin ist das thermoelektrische Element elektrisch leitend mit ersten Kontakten verbunden, die an dem ersten Ende und an dem zweiten Ende vorgesehen sind. Damit kann ein Stromfluss, ausgehend von dem jeweiligen thermoelektrischen Element hin zu Spannungspotentialen außerhalb des Moduls, erzeugt werden. Die so erzeugte elektrische Energie kann somit an eine Batterie oder einen Verbraucher weitergeleitet werden.

Das Modul ist durch das innere Rohr hindurch für ein Fluid oder für ein Kühlmittel durchströmbar ausgeführt. Das Modul wird bei Einsatz in einem thermoelektrischen Generator um sein äußeres Rohr herum von einem Fluid oder einem Kühlmittel überströmt, so dass ein Wärmepotential zwischen äußerem Rohr und innerem Rohr über das thermoelektrische Element hinweg vorliegt.

Gemäß einer vorteilhaften Ausführungsform des Moduls bilden die elektrisch leitenden ersten Kontakte eine Abdichtung zwischen dem äußeren Rohr und dem inneren Rohr. Dies bedeutet insbesondere, dass die elektrisch leitenden ersten Kontakte in den Bereichen, in denen sie zwischen innerem Rohr und äußerem Rohr angeordnet sind, eine Abdichtung gegenüber dem Fluid und/oder dem Kühlmittel bilden, so dass diese nicht in den Raum zwischen innerem Rohr und äußerem Rohr eindringen können. Damit ist sicher verhindert, dass Korrosion oder ein Kurzschluss der thermoelektrischen Elemente entsteht. Auch wenn bevorzugt ist, dass die ersten Kontakte allein die Abdichtung bilden, kann es auch erforderlich sein, neben den elektrisch leitenden ersten Kontakten weitere Mittel zur Abdichtung des ersten Endes und/oder zweiten Endes vorzusehen (Dichtungsmasse, Stopfen, etc.).

Gemäß einer weiteren vorteilhaften Ausführungsform des Moduls ist zumindest ein Kompensationselement im äußeren Rohr zum Ausgleich unterschiedlicher Ausdehnungen des inneren Rohres gegenüber dem äußeren Rohr vorgesehen. Mit einem Kompensationselement ist hier insbesondere ein Mittel für einen Längenausgleich gemeint, das dazu dient, dass bei einer großen Temperaturdifferenz zwischen äußerem Rohr und innerem Rohr eine unterschiedliche (material- und temperaturabhängige) Längenausdehnung des inneren Rohrs gegenüber dem äußeren Rohr kompensiert wird. Dabei weist das äußere Rohr insbesondere eine Art Faltenbalg als Kompensationselement auf, dessen Falten sich von der Umfangsfläche des äußeren Rohres nach außen hin erstrecken. Das Kompensationselement ist dabei insbesondere um den Umfang des Moduls umlaufend vorgesehen, so dass das Modul durch das Kompensationselement in axiale Teilbereiche unterteilt wird. Dabei ist es insbesondere vorteilhaft, dass das Kompensationselement aus einem gleichartigen Material wie das äußere Rohr hergestellt ist. Als Material für das äußere Rohr und/oder das inneres Rohr sind insbesondere metallische Legierungen vorgesehen, z. B. (hochlegierte) Chrom-Nickel-Stähle wie WN 1.4301, WN 1.4828 und WN 1.4607 (Bezeichnung insbesondere nach DIN EN-10027-2), aber auch Aluminium- oder Kupfer-Legierungen. Ein Stahl mit der Werkstoffnummer (WN) 1.4828 weist max. 0,2 Gewichts-% Kohlenstoff, 1,5 bis 2,5 Gew.-% Silizium, max. 2 Gew.-% Mangan, max. 0,045 Gew.-% Phosphor, max. 0,03 Gew.% Schwefel, 19-21 Gew.-% Chrom und 11 bis 13 Gew.% Nickel auf. Ein Stahl mit der Werkstoffnummer 1.4301 weist max. 0,07 Gewichts-% Kohlenstoff, max. 1 Gew.-% Silizium, max. 2 Gew.% Mangan, max. 0,045 Gew.% Phosphor, 17-19,5 Gew.% Chrom, 8 bis 10,5 Gew.% Nickel und max. 0,11 Gew.% Stickstoff auf. Die verwendeten Materialen für das äußere Rohr und das innere Rohr können insbesondere auch unterschiedlich gewählt sein, so dass unter Berücksichtung der Kontaktierung des inneren und äußeren Rohrs mit entweder dem heißen Fluid oder dem kälteren Kühlmittel, und unter Beachtung z. B. der unterschiedlichen Wärmeausdehnung des einzusetzenden Materials, eine entsprechende Auslegung des Moduls erfolgen kann.

Gemäß einer weiteren vorteilhaften Ausführungsform des Moduls ist die Anzahl der Kompensationselemente entlang der Länge des Moduls in Abhängigkeit eines Wärmeausdehnungskoeffizienten des Materials des äußeren Rohres und/oder des Materials des inneren Rohres und/oder in Abhängigkeit der Temperaturdifferenz (im Betrieb) zwischen äußerem Rohr und innerem Rohr festgelegt. Je höher die Temperaturdifferenz und/oder je höher (oder unterschiedlicher) die Wärmeausdehnungskoeffizienten, umso mehr Kompensationselemente sind entlang der Länge des Moduls vorzusehen.

Insbesondere ist bei dem Modul ein Kompensationselement in einer Distanz von 2 cm bis 10 cm zu dem ersten Ende und/oder zu dem zweiten Ende und/oder gegenüber einem weiteren Kompensationselement angeordnet. Bevorzugt ist, dass das Modul so gestaltet ist, dass ausgehend von einem Ende bis hin zum anderen Ende in einer Distanz jeweils von 3 cm bis 5 cm ein umlaufendes Kompensationselement vorgesehen ist.

Zur Lösung der eingangs genannten Aufgaben ist weiter ein elektrischer Leiter zur elektrisch leitenden Verbindung mehrere Module mit einer Elektrode oder einem Gehäuse vorgesehen, wobei der elektrische Leiter plattenförmig ist und eine erste Stirnfläche und eine zweite Stirnfläche sowie eine umlaufende Umfangsfläche aufweist. Dabei ist die erste Stirnseite mit der zweiten Stirnseite über zumindest eine Öffnung verbunden. Die zumindest eine Öffnung ist zur Aufnahme jeweils eines Moduls vorgesehen. Der elektrische Leiter weist elektrische leitende zweite Kontakte auf zur elektrisch leitenden Verbindung der ersten Kontakte der einzeinen Module mit dem elektrischen Leiter.

Insbesondere ist der hier vorgeschlagene elektrische Leiter zwischen der ersten Stirnfläche und der zweiten Stirnfläche nur 0,5 bis 5 mm dick ausgeführt und hat insbesondere keine stützende Funktion für die Anordnung zumindest eines Moduls in einem thermoelektrischen Generator. Der elektrische Leiter ist im Wesentlichen plattenförmig (oder nach Art einer Scheibe oder eines Ringes) aufgebaut, wobei insbesondere elektrische Anschlüsse auf seiner ersten und/oder zweiten Stirnfläche im Bereich der Öffnungen vorgesehen sind, die als elektrische leitende zweite Kontakte zur elektrisch leitenden Verbindung der ersten Kontakte des Moduls mit dem elektrischen Leiter gestaltet sind. Insbesondere sind die elektrisch leitenden zweiten Kontakte so ausgeführt, dass sie flanschartige Anschlüsse um die Öffnungen der elektrischen Leiters bilden, die in den Zwischenraum zwischen innerem Rohr und äußeren Rohr des Moduls einschiebbar sind, so dass sie zumindest über einen Teil des Umfangs des Moduls mit den elektrisch leitenden ersten Kontakten des Moduls in elektrisch leitender Verbindung stehen. Dadurch wird ein elektrischer Strom, der über die thermoelektrischen Elemente des Moduls erzeugt wird, durch die ersten Kontakte auf die zweiten Kontakte und damit auf den elektrischen Leiter übertragen.

Der elektrische Leiter ist bevorzugt aus dem selben Material wie das äußere und/oder innere Rohr und/oder das Gehäuse eines thermoelektrischen Generators ausgeführt.

Der elektrische Leiter dient dazu, die thermoelektrischen Elemente eines Moduls insbesondere mit einem Gehäuse (als elektrische Masse) eines thermoelektrischen Generators elektrisch leitend zu verbinden, so dass insbesondere ein elektrisch leitender Kontakt mit Masse ermöglicht ist. Gegenüberliegend kann z. B. ein praktisch gleichermaßen ausgestalteter Leiter elektrisch leitend mit einer (positiven) Elektrode verbunden werden.

Der elektrische Leiter kann auch dazu vorgesehen sein, die thermoelektrische Elemente eines Moduls über seine plattenförmige Erstreckung elektrisch leitend mit einer Elektrode zu verbinden, die mit Stromleitungen außerhalb des Gehäuses eines thermoelektrischen Generators verbindbar ist. Dazu ist der elektrische Leiter gegenüber dem Gehäuse elektrisch isoliert anzuordnen. Hinsichtlich der Ausführung einer abdichtenden beziehungsweise isolierenden Verbindung zwischen elektrischem Leiter und Gehäuse und insbesondere einer abdichtenden und isolierten Durchführung einer Elektrode durch ein Gehäuse eines thermoelektrischen Generators wird auf die DE-A1-43 03 581 verwiesen, die hiermit vollständig in Bezug genommen wird. Die dort beschriebenen Mantelrohre sind mit dem Gehäuse der vorliegenden Erfindung funktionell gleichzusetzen, wobei die dort angeführten Elektroden mit dem in dieser Erfindung angeführten elektrischen Leiter in elektrisch leitender Verbindung stehen würden.

Eine Abdichtung einer Durchführung einer Elektrode beziehungsweise eines Stromleiters durch das Gehäuse eines thermoelektrischen Generators nach außen und/oder eines elektrischen Leiters innerhalb eines Gehäuses wird insbesondere hinsichtlich eines gasförmigen Fluids, insbesondere eines Abgases einer Verbrennungskraftmaschine, vorgeschlagen.

Gemäß einem weiteren Aspekt der Erfindung wird ein thermoetektrischer Generator angegeben, der zumindest folgende Komponenten aufweist:
- mehrere Module,
- wenigstens einen Fluideintritt und einen Fluidaustritt,
- wenigstens einen Kühlmitteleintritt und einen Kühlmittelaustritt, und
- ein Gehäuse,
wobei die Module zumindest an dem ersten Ende oder dem zweiten Ende über das innere Rohr oder über das äußere Rohr in einem zuvor erfindungsgemäß beschriebenen elektrischen Leiter aufgenommen sind.

Mehrere Module sind vorgesehen, wobei jedes Modul z. B. an einem Ende über das innere Rohr mit dem erfindungsgemäßen elektrischen Leiter verbunden ist und gegenüberliegend jedes Modul an dem anderen Ende über das äußere Rohr mit dem erfindungsgemäßen elektrischen Leiter verbunden ist. Der eine elektrische Leiter (erster elektrischer Leiter) kann dann bevorzugt mit dem die elektrische Masse bildenden Gehäuse und der andere elektrische Leiter (zweiter elektrischer Leiter) mit der Elektrode verbunden sein.

Anstatt des erfindungsgemäßen elektrischen Leiters können grundsätzlich auch andere elektrische leitende Verbindungen der Module mit einer Elektrode oder einem Gehäuse vorgesehen sein, z. B. Kabelverbindungen. Eine Ausführung mit einem erfindungsgemäßen elektrischen Leiter ist hier zu bevorzugen, weil dieser insbesondere beim Anordnen in einem von einem Fluid oder einem Kühlmittel durchströmten Bereich eine gute Dauerfestigkeit aufweist und somit eine dauerhafte Funktionsfähigkeit und damit Wartungsfreiheit des thermoelektrischen Generators gewährleisten kann.

Der thermoelektrische Generator weist gemäß einer besonders bevorzugten Ausführungsform zwischen 10 und 50 Module auf, die (parallel) nebeneinander angeordnet sind und an ihrem jeweiligen Ende durch jeweils einen elektrischen Leiter miteinander und/oder mit einer Elektrode und/oder mit einem Gehäuse verbunden sind. Ganz besonders bevorzugt ist eine Ausgestaltung des thermoelektrischen Generators mit 20 bis 30 Modulen.

Ein Fluideintritt und ein Fluidausstritt sind insbesondere an einer ersten Stirnseite beziehungsweise an einer zweiten Stirnseite des thermoelektrischen Generators vorgesehen, so dass das Fluid durch die Module hindurchströmt. Ein Kühlmitteleintritt und ein Kühlmittelaustritt sind dann dementsprechend an einer Umfangsfläche des Gehäuses angeordnet, so dass die Module von dem Kühlmittel auf ihrer Außenoberfläche überströmt werden. Gegebenenfalls ist der Eintritt/Austritt für Fluid und Kühlmittel umgekehrt ausgeführt, so dass ein Kühlmittel die Module durchströmt und ein Fluid die Module auf ihrer Außenoberfläche überströmt.

Der Fluideintritt und der Fluidaustritt können insbesondere als Teil einer Abgasanlage öder einer Abgasleitung ausgeführt sein. Es ist insbesondere aber auch möglich, dass mehrere Fluideintritte und/oder mehrere Fluidaustritte vorgesehen sind.

Die elektrischen Leiter sind innerhalb des Gehäuses des thermoelektrischen Generators vorgesehen, so dass ein innerhalb der Module durch thermoelektrische Elemente erzeugter elektrischer Strom über die elektrischen Leiter hin zum Gehäuse beziehungsweise zu einer Elektrode außerhalb des Gehäuses geleitet wird.

Gemäß einer besonders vorteilhaften Ausführungsform kann das gesamte Gehäuse des thermoelektrischen Generators gegenüber weiteren Komponenten eines Kraftfahrzeuges oder einer umgebenden Anlage, insbesondere gegenüber einer mit dem Gehäuse verbunden Abgasanlage, elektrisch isoliert ausgeführt werden. Diesbezüglich wird auf die DE-A1-44 29 878 verwiesen, die diesbezüglich hier-mit vollumfänglich in Bezug genommen wird, in der insbesondere die Isolation einer Abgasbehandlungseinheit gegenüber einer mit dieser verbundenen Abgasanlage bereits offenbart ist.

Gemäß einer vorteilhaften Weiterbildung ist der thermoelektrische Generator als Ersatz für einen konventionellen Wärmetauscher, insbesondere für einen Wärmetauscher einer Verbrennungskraftmaschine, vorgesehen. Die Eintritte/Austritte für ein Fluid beziehungsweise ein Kühlmittel können von dem Wärmetauscher unverändert übernommen werden, wobei durch den thermoelektrischen Generator weiterhin zumindest eine Stromelektrode (Pluspol) bereitgestellt ist, der zum Abführen des in dem thermoelektrischen Generator erzeugten elektrischen Stroms vorgesehen ist.

Gemäß einer weiteren vorteilhaften Weiterbildung des thermoelektrischen Generators ist zumindest ein Stützelement vorgesehen, dass mit dem Gehäuse und dem zumindest einen Modul verbunden ist und mit dem Gehäuse und dem zumindest einen Modul eine Abdichtung gegenüber einem Fluid und/oder einem Kühlmittels ausbildet. Das Stützmittel ist insbesondere ähnlich dem erfindungsgemäßen elektrischen Leiter als Plattenelement mit Öffnungen ausgeführt und ist stoff-, form- und/oder kranschlüssig mit dem äußeren Rohr und/oder dem inneren Rohr des Moduls sowie dem Gehäuse verbunden. Das Stützelement dient dazu, die einzelnen Module in einem Gehäuse eines thermoelektrischen Generators zu fixieren und anzuordnen und somit eine dauerfeste Abstützung der Module in dem Gehäuse zu ermöglichen. Darüber hinaus dienen die Stützelemente insbesondere der Abdichtung innerhalb des Gehäuses zwischen dem Bereich der von einem Fluid und dem Bereich der von einem Kühlmittel durchströmt wird. Auch hier ist die Abdichtung insbesondere mit weiteren speziellen Dichtmitteln ausgeführt.

Gemäß einer besonders vorteilhaften Ausgestaltung der Ausführungsform sind die Funktionen zumindest eines Stützelementes und eines elektrischen Leiters in einem Bauteil zusammengeführt. Dadurch können die Stützfunktion der einzelnen Module sowie die Abdichtung und die elektrische Leitung des in dem Modul erzeugten elektrischen Stromes durch ein Bauteil erfolgen.

Gemäß einer weiteren vorteilhaften Ausführungsform weist das Gehäuse des thermoelektrischen Generators zumindest ein Kompensationselement auf. Auch dieses Kompensationselement ist insbesondere in gleicher Weise wie das bereits beschriebene Kompensationselement des Moduls ausgeführt. Hier ist also auch insbesondere ein Faltenbalg vorzusehen, der insbesondere Wärmedehnungen gegenüber einer unterschiedlichen Ausdehnung der in dem Gehäuse angeordneten Module zulässt.

Gemäß einer Weiterbildung des thermoelektrischen Generators weist das zumindest eine Modul zumindest eine Struktur zur Strömungsbeeinflussung zumindest des Fluids und/oder des Kühlmittels und/oder zur Wärmeleitung zumindest vom Fluid und/oder Kühlmittel hin zum inneren Rohr oder äußeren Rohr auf. Derartige Strukturen sind für Strömungskanäle und Strömungspfade z. B. Elemente zur Strömungsbeeinflussung und/oder Leitschaufeln und/oder Wärmeleitstrukturen. Diese Strukturen können auf der Außenfläche des äußeren Rohres und/oder auf der Innenfläche des inneren Rohres vorgesehen sein, so dass das diese Flächen überströmende Fluid und/oder Kühlmittel dementsprechend beeinflusst werden kann.

Gemäß einer besonders vorteilhaften Weiterbildung kann der thermoelektrische Generator auf unterschiedliche Arten von thermoelektrischen Elementen aufweisen.

Gemäß einer weiteren vorteilhaften Ausführungsform beträgt die Verlustleistung des thermoelektrischen Generators höchstens 10 %. Dabei ist die Verlustleistung der Anteil der durch die thermoelektrischen Elemente erzeugten elektrischen Leistung, die infolge von Übergangswiderständen in den elektrischen Leitern zwischen den thermoelektrischen Elementen als Wärmeleistung innerhalb des thermoelektrischen Generators verlören geht.

Außerdem kann auch vorgesehen sein, dass eine Zusatzkühlung für zumindest einen Teil eines Moduls vorhanden ist. Ganz besonders bevorzugt ist die Zusatzkühlung eine (elektrische beziehungsweise elektromechanische) Umkehr-Schaltung der thermoelektrischen Elemente, so dass diese als Peltier-Elemente wirken. Damit können sie dann sich selbst kühlen für den Fall, dass zu heißes Abgas durch den thermoelektrischen Generator strömt.

Der erfindungsgemäße thermoelektrische Generator wird bevorzugt in einem Kraftfahrzeug mit einem Verbrennungsmotor und einer Abgasleitung eingesetzt, wobei das zumindest eine erfindungsgemäße Modul von Abgas durchströmt wird. Bei einer derartigen Anordnung eines thermoelektrischen Generators in einer Albgasleitung eines Kraftfahrzeuges ist es insbesondere auch vorgesehen, dass das Kühlmittel durch das Modul hindurchströmt und dementsprechend das Abgas innerhalb des Gehäuses des thermoelektrischen Generators die Module überströmt. Insbesondere wird als Kühlmittel Kühlwasser eingesetzt, wobei auch andere Kühlmittel wie Öle einsetzbar sind.

Gemäß einer vorteilhaften Weiterbildung wird ein Kraftfahrzeug mit einem Verbrennungsmotor und einer Abgasleitung sowie einer Abgasrückführungsleitung vorgeschlagen, in der ein erfindungsgemäßer thermoelektrischer Generator angeordnet ist.

Es wird weiter ein Verfahren zur Herstellung eines Moduls vorgeschlagen, umfassend zumindest die folgenden Schritte:
a1. Bereitstellen eines inneren Rohrs mit einem Querschnitt und einer äußeren Umfangsfläche,
a2. Beschichten zumindest eines Teils der äußeren Umfangsfläche mit
   i) einem Dielektrikum (39), und
   ii) einem Leiterbahnmaterial (40) zur Erzeugung von Leiterbahnen (19),
a3. Aufbringen von Halbleitermaterial (41) oder von zumindest einem thermoelektrischen Element (7);
   und weiter
b1. Bereitstellen eines äußeren Rohrs (6) mit einer Innenfläche (42),
b2. Aufbringen auf zumindest einen Teil (38) der Innenfläche (42)
   i) ein Dielektrikum (39), und
   ii) Leiterbahnmaterial (40) zur Erzeugung von Leiterbahnen (19), und weiter
c1. Zusammenführen des äußeren Rohrs (6) und des inneren Rohrs (5),
wobei in dem Schritt b2 ii) das Leiterbahnmaterial (40) in Form eines inneren profilierten Rohres (47) mit einem minimalen Innendurchmesser (43) in das äußere Rohr (6) eingeschoben und mit diesem verbunden wird und gemäß einem weiteren Schritt b3. der minimale Innendurchmesser (43) aufgeweitet wird.

Es wird weiter ein Verfahren zur Herstellung eines Moduls (1) vorgeschlagen, umfassend zumindest die folgenden Schritte:
a1. Bereitstellen eines inneren Rohrs (5) mit einem Querschnitt (36) und einer äußeren Umfangsfläche (37),
a2. Beschichten zumindest eines Teils (38) der äußeren Umfangsfläche (37) mit
   i) einem Dielektrikum (39), und
   ii) einem Leiterbahnmaterial (40) zur Erzeugung von Leiterbahnen (19),
a3. Aufbringen von Halbleitermaterial (41) oder von zumindest einem thermoelektrischen Element (7);
   und weiter
b1. Bereitstellen eines äußeren Rohrs (6) mit einer Innenfläche (42),
b2. Aufbringen auf zumindest einen Teil (38) der Innenfläche (42)
   i) ein Dielektrikum (39), und
   ii) Leiterbahnmaterial (40) zur Erzeugung von Leiterbahnen (19), und weiter
c1. Zusammenführen des äußeren Rohrs (6) und des inneren Rohrs (5),
   wobei das auf die Umfangsfläche (37) des inneren Rohrs (5) aufgetragene Halbleitermaterial (41) nach Schritt a3. in einem Schritt a4. dotiert wird zur Bildung von zumindest einem thermoelektrischen Element (7).

Die oben angeführten Teilprozesse a. und b. können getrennt und zeitlich unabhängig voneinander aufgeführt werden. Die Prozessschritte innerhalb der Teilprozesse sind in der angegebenen sukzessiven Reihenfolge durchzuführen.

Besonders vorteilhaft wird die Beschichtung des inneren Rohres beziehungsweise des äußeren Rohres mit einem Dielektrikum durch ein Tauchbad vorgenommen. Für die Beschichtung des inneren Rohres, beziehungsweise äußeren Rohres mit einem Leiterbahnmaterial, wird dann das bereits mit dem Dielektrikum beschichtete Rohr entweder in ein Leiterbahnmaterialtauchbad eingetaucht oder das Leiterbahnmaterial z. B. mittels Siebdruck insbesondere auf die äußere Umfangsfläche des inneren Rohres aufgetragen.

Auch das Aufbringen von Halbleitermaterial kann hier im Tauchbad erfolgen. Weiter kann das Halbleitermaterial auch in Form von unterschiedlich dotierten ringförmigen Elementen auf das innere Rohr aufgeschoben werden, so dass in axialer Richtung des Moduls unterschiedlich dotierte Halbleiter durch elektrisch leitende Verbindung durch die elektrischen Leiterbahnen zu einem elektrothermischen Element zusammengeschaltet werden können.

Neben dem Auftrag als Halbleitermaterial kann in einer bevorzugten Ausführungsform auch ein thermoelektrisches Element direkt auf das entsprechend vorbereitete Innenrohr aufgebracht werden und abhängig von der Ausführungsform des thermoelektrischen Elementes mit anderen thermoelektrischen Elementen parallel oder hintereinander geschaltet werden. Dabei ist bevorzugt, dass ein größtmöglicher Teil der Umfangsfläche des inneren Rohres mit thermoelektrischen Elementen versehen wird. Insbesondere bei der Verwendung von rechteckigen Querschnitten eines inneren Rohres werden die größeren Seitenflächen mit thermoelektrischen Elementen belegt und die kleineren Seitenflächen frei gelassen, so dass eine engere Anordnung einzelner Module innerhalb eines Gehäuses eines thermoelektrischen Generators ermöglicht wird.

Da die innere Oberfläche des äußeren Rohres mit einem Dielektrikum und mit Leiterbahnmaterial beschichtet wird und regelmäßig die Querschnitte des äußeren Rohres so klein sind, dass eine Bearbeitung der inneren Oberfläche nicht möglich ist, werden hier Dielektrikum und Leiterbahnmaterial bevorzugt in einem Tauchprozess auf die innere Oberfläche des äußeren Rohres aufgetragen.

Gemäß einer vorteilhaften Ausführungsform des Verfahrens wird, zur Herstellung von Leiterbahnen in bevorzugten Bereichen des äußeren Rohres, so dass applizierte thermoelektrische Elemente beziehungsweise entsprechend dotiertes Halbleitermaterial auf dem inneren Rohr entsprechend verschaltet werden können/kann, nach Schritt b2. i) in das äußere Rohr mit einer glatten Innenfläche und mit der Dielektrikum-Beschichtung in einem Schritt b2. ii) ein inneres profiliertes Rohr aus Leiterbahnmaterial zur Erzeugung der Leiterbahnen eingeschoben und mit dem äußeren Rohr verbunden, insbesondere verlötet. Dabei weist das innere profilierte Rohr einen ersten minimalen Innendurchmesser und eine Profilierung nach außen auf, ist also nur in Teilbereichen mit dem äußeren Rohr, beziehungsweise mit der Dielektrikum-Beschichtung in Kontakt. Das innere profilierte Rohr bildet nach den Schritten i) und ii) des Schrittes b2. also einen ersten minimalen Innendurchmesser durch die (glatte) Innenfläche des inneren profilierten Rohres, der in einem Schritt b3. (insbesondere durch einen Ausbohrprozess) erweitert wird. Dabei wird das Material des inneren profilierten Rohres soweit abgetragen, dass das Material des inneren profilierten Rohres nur noch in Teilbereichen am äußeren Rohr vorliegt und dementsprechend Leiterbahnen gebildet sind. Somit wird eine (nahezu) ebene Oberfläche an der Innenfläche des äußeren Rohres erzeugt, so dass bei Zusammenführen des äußeren Rohres und des inneren Rohres eine entsprechende Leiterbahnanordnung sowohl auf der Außenfläche des inneren Rohres wie auch auf der Innenfläche des äußeren Rohres gebildet ist und ein entsprechender Strompfad über die thermoelektrischen Elemente erzeugbar ist.

Gemäß einer vorteilhaften Ausführungsform des Verfahrens weist das Modul ein erstes Ende und ein zweites Ende auf und die elektrischen Leiterbahnen werden an dem ersten Ende und dem zweiten Ende mit zumindest jeweils einem elektrischen Kontakt elektrisch leitend verbunden. Dabei kann der elektrische Kontakt hier als Kabel oder ähnliches ausgeführt sein, der den durch die thermoelektrischen Elemente erzeugten elektrischen Strom zu Bereichen außerhalb des Moduls leiten kann. Insbesondere ist der elektrische Kontakt jedoch so ausgebildet, dass eine insbesondere gasdichte Abdichtung zwischen äußerem Rohr und innerem Rohr erzeugt wird und der elektrische erste Kontakt mit dem vorgeschlagenen erfindungsgemäßen elektrischen Leiter in elektrisch leitender Verbindung ist.

Gemäß einer weiteren vorteilhaften Ausführungsform des Verfahrens wird das auf der äußeren Umfangsfläche des inneren Rohres aufgetragene Halbleitermaterial nach dem Schritt a3. in einem weiteren Schritt a4. dotiert, so dass zumindest ein thermoelektrisches Element derart gebildet wird.

Die Erfindung sowie das technische Umfeld werden anhand der schematischen Figuren veranschaulicht. Es ist darauf hinzuweisen, dass die Figuren besonders bevorzugte Ausführungsvarianten zeigen, die Erfindung jedoch nicht darauf beschränkt ist. Es zeigen schematisch:
- Fig. 1:: die Integration des thermoelektrischen Generators in einem Kraftfahrzeug;
- Fig. 2:: ein inneres Rohr gemäß Schritt al.;
- Fig. 3:: das innere Rohr gemäß Schritt a2. i);
- Fig. 4:: das innere Rohr gemäß Schritt a2. ü);
- Fig. 5:: das innere Rohr gemäß Schritt a3. mit Halbleitermaterial;
- Fig. 6:: das innere Rohr gemäß Schritt a3. mit thermoelektrischen Elementen;
- Fig. 7:: ein äußeres Rohr gemäß Schritt b1.;
- Fig. 8:: das äußere Rohr gemäß Schritt b2. i);
- Fig. 9:: das äußere Rohr vor einem Schritt b3.;
- Fig. 10:: das äußere Rohr gemäß Schritt b2. ii) oder gemäß Schritt b3.;
- Fig. 11:: das innere Rohr und das äußere Rohr vor dem Zusammenführen gemäß Schritt c1.;
- Fig. 12:: eine weitere Ausgestaltung eines Moduls für einen thermoelektrischen Generator;
- Fig. 13:: eine Ausgestaltung des elektrischen Leiters in einer Seitenansicht und in einer Schnittdarstellung;
- Fig. 14:: eine weitere Ausgestaltung eines thermoelektrischen Generators, und
- Fig. 15:: eine noch andere Ausgestaltung eines thermoelektrischen Generators.

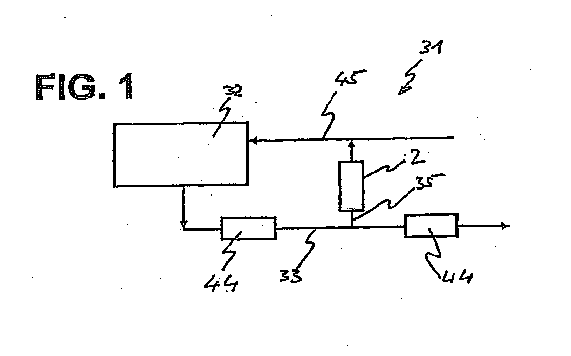

Fig. 1 veranschaulicht schematisch den bevorzugten Einsatzzweck eines thermoelektrischen Generators 2. Dabei ist ein Kraftfahrzeug 31 mit einer Verbrennungskraftmaschine 32 gezeigt. Das in der Verbrennungskraftmaschine 32, beispielsweise einem Otto-Motor oder einem Diesel-Motor, erzeugte Abgas strömt durch eine Abgasleitung 33 durch unterschiedliche Abgasbehandlungseinheiten 44 und durch den thermoelektrischen Generator 2, der hier in einer Abgasrückführungsleitung 35 angeordnet ist, die die Abgasleitung 33 mit der Lunzuführung 45 der Verbrennungskraftmaschine 32 verbindet. Ein Einbau des thermoelektrischen Generators 2 in einer Abgasrückführungsleitung 35 ist insbesondere deshalb vorteilhaft, da hier regelmäßig Wärmetauscher vorgesehen sind, die nun durch einen thermoelektrischen Generator 2 ersetzt werden können. Dadurch werden keine zusätzlichen Abgasbehandlungseinheiten 44 in das Abgassystem einer Verbrennungskraftmaschine 32 zusätzlich integriert, so dass insbesondere die bestehenden räumlichen Gegebenheiten eines Kraftfahrzeuges 31 genutzt werden.

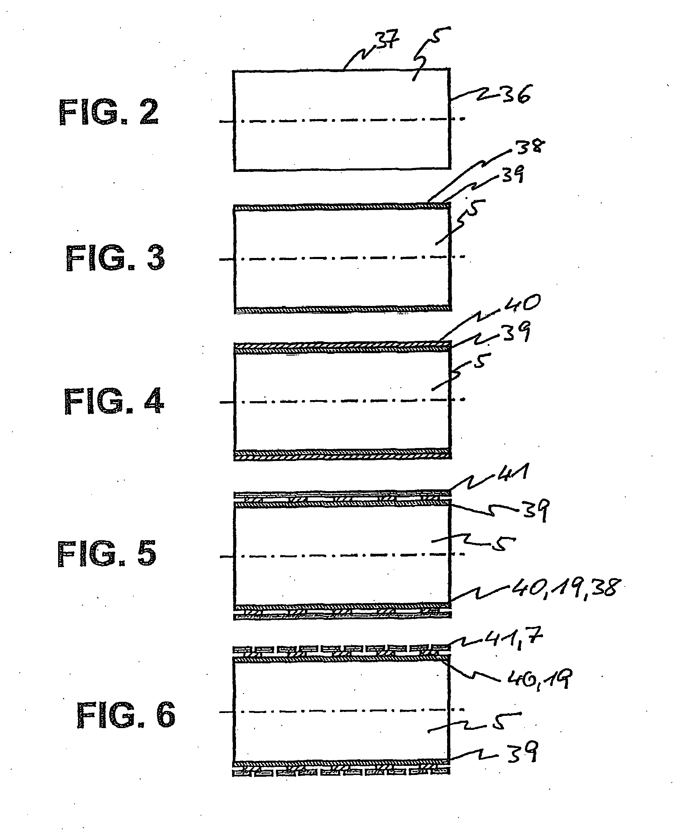

Die Fig. 2 bis 12 veranschaulichen die Herstellung eines Moduls 1 des thermoelektrischen Generators. Dabei zeigt Fig. 2 ein inneres Rohr 5 mit einer äußeren Umfangsfläche 37 und einem Querschnitt 36, der insbesondere rund oder mehreckig, insbesondere rechteckig, ausgeführt sein kann.

Fig. 3 zeigt das innere Rohr 5 gemäß dem Verfahrensschritt a2. i) zur Herstellung des Moduls 1, wobei hier die äußere Umfangsfläche 37 des inneren Rohrs 5 mit einer Beschichtung mit einem Dielektrikum 39 versehen wurde. Insbesondere ist hier nicht die gesamte äußere Umfangsfläche 37 des inneren Rohrs 5 mit einem Dielektrikum 39 beschichtet, sondern nur ein Teil 38 der äußeren Umfangsfläche 37. Insbesondere bei flachen rechteckigen Rohren sind dann nur die größeren Seitenflächen zu beschichten, so dass bei Verwendung mehrerer Module 1 in einem thermoelektrischen Generator eine engere Anordnung der Module 1 realisiert werden kann.

Fig. 4 zeigt das innere Rohr 5 gemäß Verfahrensschritt a2 ii), wobei außen auf die Beschichtung mit Dielektrikum 39 eine weitere Beschichtung mit Leiterbahnmaterial 40 aufgetragen wurde. Das Leiterbahnmaterial 40 ist hier als durchgängige Beschichtung dargestellt, jedoch können auch bereits die später verwendeten Strukturen der Leiterbahnen 19 (z. B. durch ein Siebdruckverfahren siehe Fig. 5) aufgetragen werden.

Fig. 5 zeigt das innere Rohr 5 mit einer Beschichtung mit Dielektrikum 39, einer Beschichtung mit Leiterbahnmaterial 40, die hier dargestellt ist als bereits ausgebildete Leiterbahnen 19, die nur einen Teil 38 der Umfangsfläche 37 des inneren Rohres 5 bedecken. Zusätzlich weist das innere Rohr 5 nun eine Beschichtung mit Halbleitermaterial 41 auf, die hier beispielsweise durch einen Tauchprozess appliziert wurde. Das innere Rohr 5 ist somit dargestellt nach dem Verfahrensschritt a3. Die hier gezeigten Spalte zwischen Dielektrikum 39 und Halbleitermaterial 41 sind nur zur Verdeutlichung der Lage der Leiterbahnen 19 eingefügt. Tatsächlich sind die Leiterbahnen 19 derart dünn ausgeführt, dass das Halbleitermaterial 41 zum einen auf den Leiterbahnen 19 aufliegt und zum anderen auf dem Dielektrikum 39.

Fig. 6 zeigt eine weitere Darstellung des inneren Rohrs 5 nach Verfahrensschritt a3., wobei hier auf die bereits existierende Beschichtung mit Dielektrikum 39 und Leiterbahnmaterial 40, wobei Leiterbahnen 19 hier bereits erzeugt sind, thermoelektrische Elemente 7 aufgetragen wurde. Diese thermoelektrischen Elemente 7 können auch durch Halbleitermaterial 41 gebildet sein, das insbesondere gemäß einem weiteren Verfahrensschritt nach dem Verfahrensschritt a3. durch eine Bearbeitung in einzelne Segmente aufgeteilt wird, die insbesondere in einem späteren Schritt a4. dotiert werden, so dass ein Strompfad entlang der äußeren Umfangsfläche 37 des inneren Rohrs 5 durch das dotierte Halbleitermaterial 41, das nun ein thermoelektrisches Element 7 ist, ausgebildet werden kann. Die Segmentierung kann auch allein durch eine. Dotierung gemäß Schritt a4. erfolgen, so dass eine durchgängige Halbleiterschicht ausgebildet ist, durch die, infolge der Dotierung, ein Strompfad erzeugt werden kann.

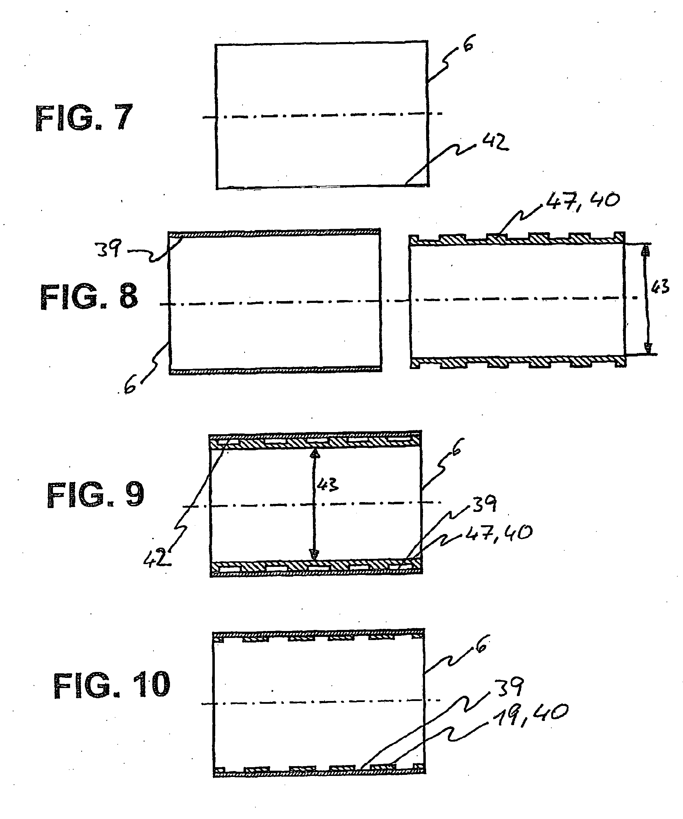

Fig. 7 zeigt ein äußeres Rohr 6 mit einer Innenfläche 42 gemäß Verfahrensschritt b1. Dabei wird der Innendurchmesser des äußeren Rohrs 6 so gewählt, dass nach den einzelnen vorzunehmenden Verfahrensschritten das innere Rohr 5 und das äußere Rohr 6 zusammengeschoben werden können und ein funktionales Modul mit sich kontaktierenden Oberflächen ergeben.

Fig. 8 zeigt in der linken Bildhälfte das äußere Rohr 6 mit einer Beschichtung von Dielektrikum 39 gemäß Verfahrensschritt b2 i). In der rechten Bildhälfte ist ein inneres profiliertes Rohr 47 dargestellt, dass aus Leiterbahnmaterial 40 besteht. Das innere profilierte Rohr 47 hat einen ersten minimalen Innendurchmesser 43.

Fig. 9 zeigt das äußere Rohr 6 mit einer weiteren Schicht bestehend aus Leitermaterial 40 zur Erzeugung von Leiterbahnen, die innen auf der Beschichtung mit Dielektrikum 39 aufliegt. Diese Schicht kann entsprechend Fig. 8 durch das Zusammenführen des äußeren Rohres 6 und eines inneren profilierten Rohres 47 aus Leiterbahnmaterial 40 erzeugt werden. Die Profilierung des inneren profilierten Rohres 47 ist nach außen ausgebildet, so dass das innere profilierte Rohr 47 nur in Teilbereichen an der Innenfläche 42 des äußeren Rohres 6, beziehungsweise an dem Dielektrikum 39, aufliegt. Fig. 9 zeigt also das äußere Rohr 6 vor einem Schritt b3. in dem dann der erste minimale Innendurchmesser 43 aufgeweitet wird.

Fig. 10 zeigt das äußere Rohr 6 gemäß einem Schritt b2. ii) oder nach einem Schritt b3., in dem der minimale Innendurchmesser 43 (s. Fig. 9) durch z. B. ein Aufbohrverfahren vergrößert wurde, und nun eine (nahezu) glatte Innenoberfläche erzeugt ist, da die Leiterbahnen 19 nur eine sehr geringe Erhebung gegenüber dem Dielektrikum 39 aufweisen. Auf dieser Innenoberfläche wechseln sich Dielektrikum 39 und Leiterbahnmaterial 40 gegenseitig ab, beziehungsweise ist eine dem inneren profilierten Rohr 47 (s. Fig. 9) entsprechende Anordnung von Dielektrikum 39 und Leiterbahnmaterial 40 ausgebildet. Das Leiterbahnmaterial 40 liegt nun nur in Teilbereichen vor und bildet entsprechende Leiterbahnen 19.

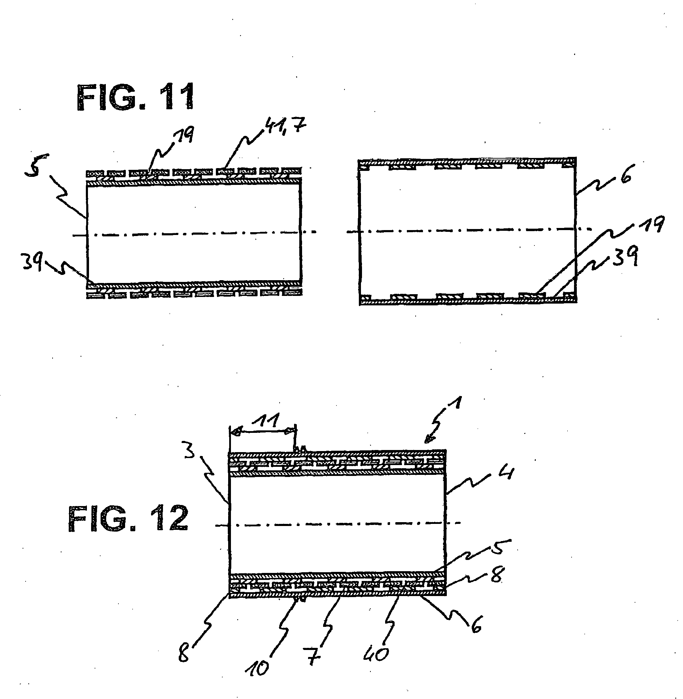

Fig. 11 zeigt in der linken Bildhälfte das innere Rohr 5 nach Verfahrensschritt a3. beziehungsweise nach Verfahrensschritt a4., wobei eine Beschichtung mit Dielektrikum 39 vorgenommen wurde und Leiterbahnen 19 ausgebildet sind. Weiterhin sind thermoelektrische Elemente 7 beziehungsweise dotiertes Halbleitermaterial 41 auf der Oberfläche derart angeordnet, dass nach Zusammenführen des inneren Rohrs 5 mit dem in der rechten Bildhälfte dargestellten äußeren Rohr 6, mit einer Struktur von Dielektrikum 39 und Leiterbahnen 19, ein Strompfad durch ein so erzeugtes Modul 1 gebildet ist.

Fig. 12 zeigt ein Modul 1, das erzeugt wurde durch das Zusammenführen (gemäß Schritt c1.) des inneren Rohrs 5 nach den Verfahrensschritten a3. beziehungsweise a4. und des äußeren Rohrs 6 nach dem Verfahrenschritt b2. ii) beziehungsweise b3. Das Modul 1 weist ein erstes Ende 3 und ein gegenüberliegend angeordnetes zweites Ende 4 auf, wobei zwischen dem äußeren Rohr 6 und dem inneren Rohr 5 thermoelektrische Elemente 7 derart angeordnet sind, dass zumindest ein elektrischer Strompfad von dem ersten Ende 3 zu dem zweiten Ende 4 gebildet ist. Auch die Ausbildung von mehreren parallelen Strompfaden ist hier möglich. Weiter sind insbesondere durch das Leiterbahnmaterial 40 erste Kontakte 8 an dem ersten Ende 3 und an dem zweiten Ende 4 gebildet, die eine elektrische Kontaktierung zu Komponenten außerhalb des Moduls 1 ermöglichen, so dass ein elektrischer Strom, der durch eine Temperaturdifferenz zwischen äußerem Rohr 6 und innerem Rohr 5 erzeugt wurde, aus dem Modul 1 abgeführt werden kann. Das äußere Rohr 6 weist weiterhin zumindest ein Kompensationselement 10, das in einer Distanz 11 zumindest von einem ersten Ende 3 angeordnet ist, auf. Dieses Kompensationselement 10 dient dazu, dass in Folge der Temperaturdifferenz zwischen äußerem Rohr 6 und innerem Rohr 5 eine unterschiedliche Wärmeausdehnung des äußeren Rohrs 6 gegenüber dem inneren Rohr 5 kompensiert werden kann, so dass keine strukturelle Beschädigung des Moduls 1 erfolgt.

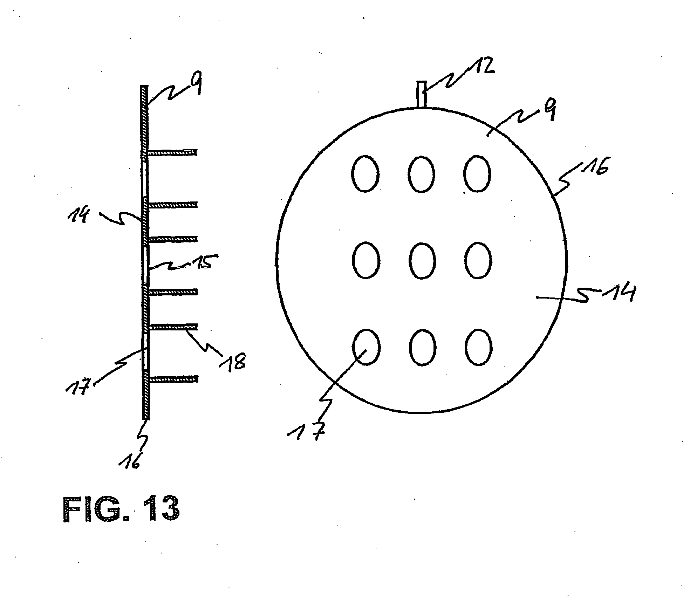

Fig. 13 zeigt in zwei Darstellungen einen elektrischen Leiter 9, der insbesondere in einem thermoelektrischen Generator eingesetzt werden kann. In der linken Bildhälfte ist der elektrische Leiter 9 in einer Seitenansicht und in der rechten Bildhälfte in einer Draufsicht dargestellt. Dabei weist der elektrische Leiter 9 eine erste Stirnfläche 14 und eine zweite Stirnfläche 15 auf, die durch Öffnungen 17 miteinander verbunden sind. Weiter weist der elektrische Leiter 9 einen äußeren Rand 16 auf. Der elektrische Leiter 9 ist zudem insbesondere mit einer Elektrode 12 verbunden, so das ein elektrischer Strom, der durch den elektrischen Leiter 9 fließt, über die Elektrode 12 abgegriffen werden kann. Dabei ist der äußere Rand 16 so gestaltet, dass insbesondere entweder eine elektrische Isolierung des Randes 16 gegenüber einem Gehäuse eines thermoelektrischen Generators 2, oder dass eine elektrische leitende Verbindung mit dem Gehäuse realisiert werden kann. Der elektrische Leiter 9 weist zudem insbesondere zweite Kontakte 18 auf, die elektrisch leitend mit dem elektrischen Leiter 9 verbunden sind. Diese können insbesondere stoffschlüssig mit diesem verbunden sein. Insbesondere sind die zweiten Kontakte 18 derart ausgeführt, dass sie die Öffnungen 17 zumindest teilweise umgeben. Dabei sind die zweiten Kontakte 18 zur elektrisch leitenden Verbindung des elektrischen Leiters 9 mit den Modulen vorgesehen, so dass ein in den Modulen erzeugter elektrischer Strom über den elektrischen Leiter 9 hin zu Komponenten eines Kraftfahrzeuges oder einer Anlage abgeführt werden kann.

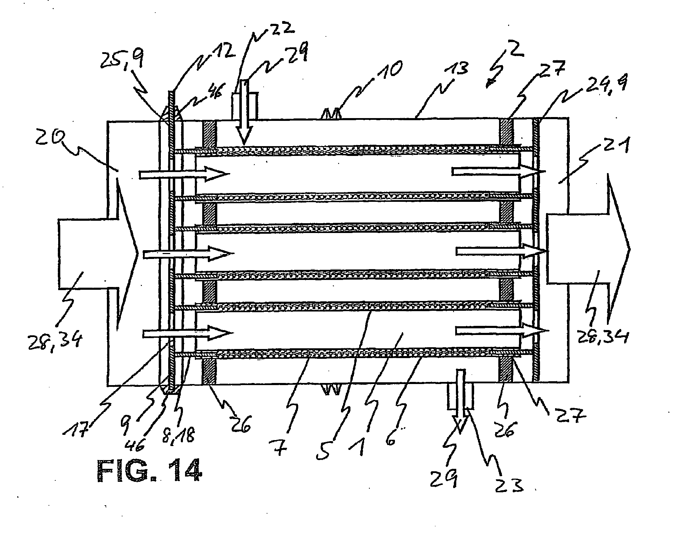

Fig. 14 zeigt eine erste Ausgestaltung eines thermoelektrischen Generators 2. Dieser weist ein Gehäuse 13 auf, in dem mehrere Module 1 vorgesehen sind. Dabei weist das Gehäuse 13 einen Fluideintritt 20 und einen Fluidaustritt 21 auf sowie einen Kühlmitteleintritt 22 und einen Kühlmittelaustritt 23. Das Gehäuse 13 des thermoelektrischen Generators 2 wird also von einem Fluid 20, insbesondere einem Abgas 34, durch den Fluideintritt 20 beziehungsweise den Fluidaustritt 21 und gleichzeitig durch ein Kühlmittel 29, das durch Kühlmitteleintritt 22 und einen Kühlmittelaustritt 23 strömt, durchströmt. Kühlmittel 29 und Fluid 28 sind dabei insbesondere durch Stützelemente 26 in Verbindung mit dem Gehäuse 13 und/oder mit den Modulen 1 voneinander abgedichtet. Die Stützelemente 26 sind insbesondere dafür vorgesehen, die Module 1 innerhalb des Gehäuses 13 des thermoelektrischen Generators 2 zu fixieren.

Die Module 1 sind aufgebaut aus einem inneren Rohr 5 und einem äußeren Rohr 6 sowie dazwischen angeordneten thermoelektrischen Elementen 7, so dass durch die von einem Fluid 28 und einem Kühlmittel 29 erzeugte Temperaturdifferenz zwischen äußerem Rohr 6 und innerem Rohr 5 des Moduls 1 ein elektrischer Strom erzeugt wird, der durch elektrische Leiter 9 aus dem Gehäuse 13 abgeführt werden kann. Dabei ist bevorzugt ein erster elektrischer Leiter 24 vorgesehen, der elektrisch leitend mit dem Gehäuse 13 und dem Modul 1 beziehungsweise den darin angeordneten thermoelektrischen Elementen 7 elektrisch leitend verbunden ist. Weiterhin ist ein zweiter elektrischer Leiter 25 vorgesehen, der ebenfalls elektrisch leitend mit den Modulen 1 und insbesondere mit den thermoelektrischen Elementen 7 des Moduls 1 elektrisch leitend verbunden ist und ein durch die Temperaturdifferenz erzeugten Strom somit über eine Elektrode 12 nach außerhalb des Gehäuses 13 abführen kann. Der zweite elektrische Leiter 25 ist dazu gegenüber dem Gehäuse 13 des thermoelektrischen Generators 2 durch eine Isolation 46 elektrisch isoliert angeordnet. Die elektrischen Leiter 9, 24, 25 sind dabei über erste Kontakte 8 beziehungsweise zweite Kontakte 18 jeweils mit den thermoelektrischen Elementen 7 der einzelnen Module 1 elektrisch leitend verbunden. Die ersten Kontakte 8 beziehungsweise die zweiten Kontakte 18 können dabei in einem Bauteil gemeinsam realisiert sein, so dass dieses Bauteil entweder an dem elektrischen Leiter 9 unverlierbar angeordnet ist, z. B. durch schweißen oder löten, oder an dem Modul 1. Der Bereich zwischen dem inneren Rohr 5 und dem äußeren Rohr 6 des Moduls 1 ist dabei zumindest durch die ersten Kontakte 8 beziehungsweise die zweiten Kontakte 18 abgedichtet, so dass ein Fluid 28 beziehungsweise ein Abgas 34 nicht in diesen Zwischenraum eindringen kann und gegebenenfalls korrosiv wirken kann.

Das Fluid 28 fließt, wie dargestellt, in das Gehäuse 13 des thermoelektrischen Generators 2 über einen Fluideintritt 20 und durchströmt die Öffnungen 17 des elektrischen Leiters 9 in die inneren Rohre 5 der einzelnen Module 1 hinein. Nach Durchströmen der Module 1 strömt das Fluid 28 erneut durch Öffnungen 17 eines weiteren elektrischen Leiters 9 und über einen Fluidaustritt 21 aus dem thermoelektrischen Generator aus. Die Module 1 werden zudem über die Oberfläche der äußeren Rohre 6 durch ein Kühlmittel 29 überströmt, so dass eine Temperaturdifferenz von innerem Rohr 5 zu äußeren Rohr 6 ausgebildet ist. Zur Kompensation einer möglichen Wärmedehnung insbesondere der Module 1 ist auch in dem Gehäuse 13 zumindest ein Kompensationselement 10 vorgesehen, das eine Ausdehnung des Gehäuses 13 des thermoelektrischen Generators 2 ermöglicht.

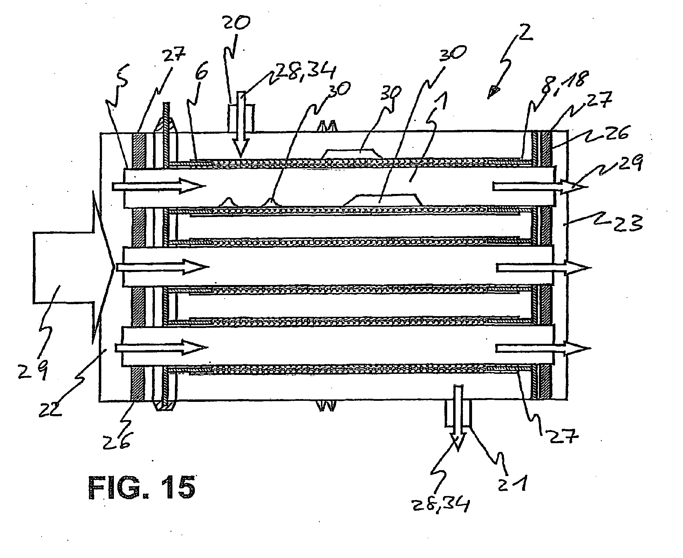

Fig. 15 zeigt eine zweite Ausgestaltung des thermoelektrischen Generators 2, wobei hier insbesondere Fluideintritt 20 und Fluidaustritt 21, Kühlmitteleintritt 22 und Kühlmittelaustritt 23 miteinander vertauscht wurden. Die Module 1 werden hier also von einem Kühlmittel 29 durch die inneren Rohre 5 durchströmt, wobei ein Fluid 28 beziehungsweise ein Abgas 34 über die Oberfläche der äußeren Rohre 6 geleitet wird. Dabei sind auch hier Stützelemente 26 vorgesehen, die mit dem Gehäuse 13 und den Modulen 1 eine Abdichtung 27 zwischen dem Bereich des Gehäuses 13, das mit einem Kühlmittel beaufschlagt ist, und dem Bereich des Gehäuses 13, das mit einem Fluid 28 beaufschlagt ist, bilden. Die Stützelemente 26 sind hier mit den inneren Rohren 5 der Module 1 verbunden, so dass diese in dem Gehäuse 13 abgestützt sind. Dadurch wird erreicht, dass der Zwischenbereich zwischen äußerem Rohr 6 und innerem Rohr 5 durch wenigstens erste Kontakte 8 beziehungsweise zweite Kontakte 18 nur gegen das Fluid 28 beziehungsweise Abgas 34 abgedichtet werden muss. Weiterhin sind hier auf der äußeren Oberfläche des äußeren Rohrs 6 Strukturen 30 vorgesehen, die eine verbesserte Wärmeleitung zwischen Fluid 28 beziehungsweise Abgas 34 und äußerem Rohr 6 ermöglichen. Ähnliche Strukturen 30 sind auch innerhalb der inneren Rohre 5 vorgesehen, die eine Turbulenz eines durchströmenden Fluids 28 oder aber auch eines durchströmenden Kühlmittels 29 hervorrufen, so dass ein besserer Wärmeübergang zwischen Fluid 28 beziehungsweise Kühlmittel 29 und dem inneren Rohr 5 ermöglicht ist. Die Strukturen 30 können auch als Wärmeleitelemente vorgesehen sein, so dass der Wärmeübergang zwischen innerem Rohr 5 zum Fluid 28 beziehungsweise zum Kühlmittel 29 hin verbessert wird.

Die in Fig. 14 und 15 gezeigten Stützelemente 26 können zusammen mit den elektrischen Leitern 9 jeweils als gemeinsame Bauteile ausgeführt sein. Die Stützfunktion der Module 1, die Funktion einer Abdichtung 27 mit Gehäuse 13 und mit den Modulen 1 sowie die Leitung eines elektrischen Stromes sind dann durch ein Bauteil realisiert.

Weiterhin kann auch der erste elektrische Leiter 24 gegenüber dem Gehäuse 13 isoliert ausgeführt sein, beziehungsweise das Gehäuse 13 isoliert ausgeführt sein gegenüber dem Abgassystem der Verbrennungskrafhnaschine 32. Dadurch würden die Module 1 gegenüber der Abgasanlage spannungstechnisch unabhängig ausgeführt sein und könnten dementsprechend mit der Masse des Kraftfahrzeugs oder dem Minuspol eines Stromversorgers verbunden sein.

### Bezugszeichenliste

- 1: Modul
- 2: Thermoelektrischer Generator
- 3: Erstes Ende
- 4: Zweites Ende
- 5: Inneres Rohr
- 6: Äußeres Rohr
- 7: Thermoelektrisches Element
- 8: Erster Kontakt
- 9: Elektrischer Leiter
- 10: Kompensationselement
- 11: Distanz
- 12: Elektrode
- 13: Gehäuse
- 14: Erste Stirnfläche
- 15: Zweite Stirnfläche
- 16: Rand
- 17: Öffnung
- 18: Zweiter Kontakt
- 19: Leiterbahn
- 20: Fluideintritt
- 21: Fluidaustritt
- 22: Kühlmitteleintritt
- 23: Kühlmittelaustritt
- 24: Erster elektrischer Leiter
- 25: Zweiter elektrischer Leiter
- 26: Stützelement
- 27: Abdichtung
- 28: Fluid
- 29: Kühlmittel
- 30: Struktur
- 31: Kraftfahrzeug
- 32: Verbrennungskraftmaschine
- 33: Abgasleitung
- 34: Abgas
- 35: Abgasrückführungsleitung
- 36: Querschnitt
- 37: Äußere Umfangsfläche
- 38: Teil
- 39: Dielektrikum
- 40: Leiterbahnmaterial
- 41: Halbleitermaterial
- 42: Innenfläche
- 43: Minimaler Innendurchmesser
- 44: Abgasbehandlungseinheit
- 45: Luftzuführung
- 46: Isolation
- 47: Inneres profiliertes Rohr

## Patentansprüche

1. **Elektrischer Leiter (9)** zur elektrisch leitenden Verbindung zumindest mehrerer Module (1) mit einer Elektrode (12) oder einem Gehäuse (13), wobei die Module aus einem inneren Rohr (5) und einem äußeren Rohr (6) sowie dazwischen angeordneten thermoelektrischen Elementen (7) aufgebaut sind, so dass durch die von einem Fluid (28) und einem Kühlmittel (29) erzeugte Temperaturdifferenz zwischen äußerem Rohr (6) und innerem Rohr (5) des Moduls (1) ein elektrischer Strom erzeugt wird, wobei der elektrische Leiter (9) plattenförmig ist und eine erste Stirnfläche (14) und eine zweite Stirnfläche (15) sowie eine Umfangsfläche (16) aufweist, wobei die erste Stirnseite (14) mit der zweiten Stirnseite (15) über zumindest mehrere Öffnungen (17) verbunden ist, wobei die zumindest mehrere Öffnungen (17) zur Aufnahme jeweils eines Moduls (1) vorgesehen sind und der elektrische Leiter (9) elektrisch leitende zweite Kontakte (18) aufweist zur elektrisch leitenden Verbindung der ersten Kontakte (8) der einzelnen Module (1) mit dem elektrischen Leiter (9).

2. Thermoelektrischer Generator (2), zumindest aufweisend
- mehrere Module (1) mit jeweils einem ersten Ende (3) und einem zweiten Ende (4), wobei die Module (1) aus einem inneren Rohr (5) und einem äußeren Rohr (6) sowie dazwischen angeordneten thermoelektrischen Elementen (7) aufgebaut sind, so dass durch die von einem Fluid (28) und einem Kühlmittel (29) erzeugte Temperaturdifferenz zwischen äußerem Rohr (6) und innerem Rohr (5) des Moduls (1) ein elektrischer Strom erzeugt wird,
- wenigstens einen Fluideintritt (20) und einen Fluidaustritt (21),
- wenigstens einen Kühlmitteleintritt (22) und einen Kühlmittelaustritt (23), und
- ein Gehäuse (13),
wobei die zumindest mehreren Module (1) zumindest an dem jeweils ersten Ende (3) oder dem jeweils zweiten Ende (4) über das innere Rohr (5) oder über das äußere Rohr (6) in einem elektrischen Leiter (9) nach Patentanspruch 1 aufgenommen ist.

3. Thermoelektrischer Generator (2) nach Patentanspruch 2, wobei zumindest ein Stützelement (26) vorgesehen ist, das mit dem Gehäuse (13) und den mehreren Modulen (1) verbunden ist, und mit dem Gehäuse (13) und den mehreren Modulen (1) eine Abdichtung (27) gegenüber einem Fluid (28) und einem Kühlmittel (29) ausbildet.

4. Thermoelektrischer Generator (2) nach Patentanspruch 2 oder 3, wobei das Gehäuse (13) zumindest ein Kompensationselement (10) aufweist.

5. Thermoelektrischer Generator (2) nach einem der Patentansprüche 2 bis 4, wobei die mehreren Module (1) jeweils zumindest eine Struktur (30) zur Strömungsbeeinflussung zumindest des Fluides (28) oder des Kühlmittels (29) und/oder zur Wärmeleitung zumindest vom Fluid (28) oder Kühlmittel (29) hin zum inneren Rohr (5) oder äußeren Rohr (6) aufweisen.

6. Kraftfahrzeug (31) mit einer Verbrennungskraftmaschine (32) und einer Abgasleitung (33) und einem thermoelektrischen Generator (2) nach einem der Patentansprüche 2 bis 5, wobei die mehreren Module (1) von Abgas (34) durchströmt werden.

7. Kraftfahrzeug (31) mit einem Verbrennungskraftmaschine (32) und einer Abgasleitung (33) und einer Abgasrückführungsleitung (35) und einem thermoelektrischen Generator (2) nach einem der Patentansprüche 2 bis 5, der in der Abgasrückführungsleitung (35) angeordnet ist.

8. **Verfahren zur Herstellung eines Moduls (1),** umfassend zumindest die folgenden Schritte:
a1. Bereitstellen eines inneren Rohrs (5) mit einem Querschnitt (36) und einer äußeren Umfangsfläche (37),
a2. Beschichten zumindest eines Teils (38) der äußeren Umfangsfläche (3 7) mit
i) einem Dielektrikum (39), und
ii) einem Leiterbahnmaterial (40) zur Erzeugung von Leiterbahnen (19),
a3. Aufbringen von Halbleitermaterial (41) oder von zumindest einem thermoelektrischen Element (7);
und weiter
b1. Bereitstellen eines äußeren Rohrs (6) mit einer Innenfläche (42),
b2. Aufbringen auf zumindest einen Teil (38) der Innenfläche (42)
i) ein Dielektrikum (39), und
ii) Leiterbahnmaterial (40) zur Erzeugung von Leiterbahnen (19), und weiter.
c1. Zusammenführen des äußeren Rohrs (6) und des inneren Rohrs (5),
wobei in dem Schritt b2 ii) das Leiterbahnmaterial (40) in Form eines inneren profilierten Rohres (47) mit einem minimalen Innendurchmesser (43) in das äußere Rohr (6) eingeschoben und mit diesem verbunden wird und gemäß einem weiteren Schritt b3. der minimale Innendurchmesser (43) aufgeweitet wird.

9. Verfahren gemäß Patentanspruch 8, wobei das Modul (1) ein erstes Ende (3) und ein zweites Ende (4) aufweist und die elektrischen Leiterbahnen (19) an dem ersten Ende (3) und dem zweiten Ende (4) mit zumindest jeweils einem elektrischen Kontakt (8, 18) elektrisch leitend verbunden werden.

10. **Verfahren zur Herstellung eines Moduls (1),** umfassend zumindest die folgenden Schritte:
a1. Bereitstellen eines inneren Rohrs (5) mit einem Querschnitt (36) und einer äußeren Umfangsfläche (37),
a2. Beschichten zumindest eines Teils (38) der äußeren Umfangsfläche (37) mit
i) einem Dielektrikum (39), und
ii) einem Leiterbahnmaterial (40) zur Erzeugung von Leiterbahnen (19),
a3. Aufbringen von Halbleitermaterial (41) oder von zumindest einem thermoelektrischen Element (7);
und weiter
b1. Bereitstellen eines äußeren Rohrs (6) mit einer Innenfläche (42),
b2. Aufbringen auf zumindest einen Teil (38) der Innenfläche (42)
i) ein Dielektrikum (39), und
ii) Leiterbahnmaterial (40) zur Erzeugung von Leiterbahnen (19),
und weiter
c1 Zusammenführen des äußeren Rohrs (6) und des inneren Rohrs (5),
wobei das auf die Umfangsfläche (37) des inneren Rohrs (5) aufgetragene Halbleitermaterial (41) nach Schritt a3. in einem Schritt a4. dotiert wird zur Bildung von zumindest einem thermoelektrischen Element (7).

## Claims

1. Electrical conductor (9) for the electrically conductive connection of at least several modules (1) to an electrode (12) or a housing (13), wherein the modules (1) are constructed from an inner tube (5) and an outer tube (6) and thermoelectric elements (7) arranged between them, so that an electrical current is generated as a result of the temperature difference, generated by a fluid (28) and a coolant (29) between the outer tube (6) and the inner tube (5) of the module (1), wherein the electrical conductor (9) is plate-shaped and has a first end face (14) and a second end face (15) and also a circumferential surface (16), wherein the first end face (14) is connected to the second end face (15) via at least several orifices (17), wherein the at least several orifices (17) are each provided for receiving one module (1), and the electrical conductor (9) has electrically conductive second contacts (18) for the electrically conductive connection of the first contacts (8) of the module (1) to the electrical conductor (9).

2. Thermoelectric generator (2), at least comprising
- several modules (1) each having a first end (3) and a second end (4), wherein the modules (1) are constructed from an inner tube (5) and an outer tube (6) and thermoelectric elements (7) arranged between them, so that an electrical current is generated as a result of the temperature difference generated by a fluid (28) and a coolant (29) between the outer tube (6) and the inner tube (5) of the module (1),
- at least one fluid inlet (20) and one fluid outlet (21),
- at least one coolant inlet (22) and one coolant outlet (23), and
- a housing (13),
wherein the at least several modules (1) are received at least at the first end (3) or the second end (4) via the inner tube (5) or via the outer tube (6) in an electrical conductor (9) as claimed in claim 1.

3. Thermoelectric generator (2) as claimed in claim 2, wherein at least one supporting element (26) is provided which is connected to the housing (13) and to the several modules (1), and which forms with the housing (13) and the several modules (1) a seal (27) with respect to a fluid (28) and a coolant (29).

4. Thermoelectric generator (2) as claimed in claim 2 or 3, wherein the housing (13) has at least one compensation element (10).

5. Thermoelectric generator (2) as claimed in one of claims 2 to 4, wherein the several modules (1) each have at least one structure (30) for influencing the flow of the fluid (28) or of the coolant (29) and/ or for the conduction of heat from the fluid (28) or coolant (29) toward the inner tube (5) or outer tube (6).

6. Motor vehicle (31) with an internal combustion engine (32) and an exhaust gas line (33) and with a thermoelectric generator (2) as claimed in one of claims 2 to 5, wherein exhaust gas (34) flows through the several modules (1).

7. Motor vehicle (31) with an internal combustion engine (32) and an exhaust gas line (33) and with an exhaust gas recirculation line (35) and a thermoelectric generator (2) as claimed in one of claims 2 to 5 which is arranged in the exhaust gas recirculation line (35).

8. Method for producing a module (1), comprising at least the following steps:
a1. provision of an inner tube (5) having a cross section (36) and having an outer circumferential surface (37),
a2. coating of at least part (38) of the outer circumferential surface (37) with
i) a dielectric (39) and
ii) a conductor track material (40) for producing conductor tracks (19),
a3. application of semiconductor material (41) or of at least one thermoelectric element (7);
and further,
b1. provision of an outer tube (6) having an inner face (42),
b2. application to at least part (38) of the inner face (42) of
i) a dielectric (39) and
ii) conductor track material (40) for producing conductor tracks (19),
and further,
c1. combining of the outer tube (6) and of the inner tube (5);
wherein in step b2. ii) the conductor track material (40), in the form of an inner profiled tube (47) with a minimum inside diameter (43), is pushed into the outer tube (6) and is connected to the latter, and, according to a further step b3., the minimum inside diameter (43) is widened.

9. Method as claimed in claim 8, wherein the module (1) has a first end (3) and a second end (4) and the electrical conductor tracks (19) are connected electrically conductively at the first end (3) and the second end (4) in each case to at least one electrical contact (8, 18).

10. Method for producing a module (1), comprising at least the following steps:
a1. provision of an inner tube (5) having a cross section (36) and having an outer circumferential surface (37),
a2. coating of at least part (38) of the outer circumferential surface (37) with
i) a dielectric (39) and
ii) a conductor track material (40) for producing conductor tracks (19),
a3. application of semiconductor material (41) or of at least one thermoelectric element (7);
and further,
b1. provision of an outer tube (6) having an inner face (42),
b2. application to at least part (38) of the inner face (42) of
i) a dielectric (39) and
ii) conductor track material (40) for producing conductor tracks (19),
wherein after step a3. the semiconductor material (41) applied to the circumferential surface (37) of the inner tube (5) is doped in a step a4. in order to form at least one thermoelectric element (7).

## Revendications

1. Conducteur électrique (9) pour la liaison électriquement conductrice d'au moins plusieurs modules (1) avec une électrode (12) ou un boîtier (13), les modules étant constitués d'un tube interne (5) et d'un tube externe (6) ainsi que d'éléments thermoélectriques (7) disposés entre ceux-ci, de sorte qu'un courant électrique soit produit par la différence de température entre le tube externe (6) et le tube interne (5) du module (1) produite par un fluide (28) et un fluide réfrigérant (29), le conducteur électrique (9) étant en forme de plaque et présentant une première surface frontale (14) et une deuxième surface frontale (15) ainsi qu'une surface périphérique (16), la première surface frontale (14) étant reliée avec la deuxième surface frontale (15) par le biais d'au moins plusieurs ouvertures (17), les au moins plusieurs ouvertures (17) étant prévues pour accueillir respectivement un module (1) et le conducteur électrique (9) présentant des deuxièmes contacts (18) électriquement conducteurs pour la liaison électriquement conductrice des premiers contacts (8) des modules (1) individuels avec le conducteur électrique (9).

2. Générateur thermoélectrique (2), présentant au moins
- plusieurs modules (1) comprenant respectivement une première extrémité (3) et une deuxième extrémité (4), les modules (1) étant constitués d'un tube interne (5) et d'un tube externe (6) ainsi que d'éléments thermoélectriques (7) disposés entre ceux-ci, de sorte qu'un courant électrique soit produit par la différence de température entre le tube externe (6) et le tube interne (5) du module (1) produite par un fluide (28) et un fluide réfrigérant (29),
- au moins une entrée de fluide (20) et une sortie de fluide (21),
- au moins une entrée de fluide réfrigérant (22) et une sortie de fluide réfrigérant (23) et
- un boîtier (13),
les au moins plusieurs modules (1) étant accueillis au moins au niveau de la première extrémité (3) respective ou de la deuxième extrémité (4) respective par le biais du tube interne (5) ou par le biais du tube externe (6) dans un conducteur électrique (9) selon la revendication 1.

3. Générateur thermoélectrique (2) selon la revendication 2, avec lequel il est prévu au moins un élément support (26) qui est relié avec le boîtier (13) et les plusieurs modules (1) et qui forme avec le boîtier (13) et les plusieurs modules (1) une garniture d'étanchéité (27) contre un fluide (28) et un fluide réfrigérant (29).

4. Générateur thermoélectrique (2) selon la revendication 2 ou 3, avec lequel le boîtier (13) présente au moins un élément de compensation (10).

5. Générateur thermoélectrique (2) selon l'une des revendications 2 à 4, avec lequel les plusieurs modules (1) présentent respectivement au moins une structure (30) pour influencer l'écoulement au moins du fluide (28) ou du fluide réfrigérant (29) et/ou pour la conductivité thermique au moins du fluide (28) ou du fluide réfrigérant (29) vers le tube interne (5) ou le tube externe (6).

6. Véhicule automobile (31) équipé d'un moteur à combustion interne (32) et d'une conduite de gaz d'échappement (33) et d'un générateur thermoélectrique (2) selon l'une des revendications 2 à 5, avec lequel les plusieurs modules (1) sont traversés par le courant des gaz d'échappement (34).

7. Véhicule automobile (31) équipé d'un moteur à combustion interne (32) et d'une conduite de gaz d'échappement (33) et d'une conduite de retour des gaz d'échappement (35) et d'un générateur thermoélectrique (2) selon l'une des revendications 2 à 5, lequel est disposé dans la conduite de retour des gaz d'échappement (35).

8. Procédé de fabrication d'un module (1), comprenant au moins les étapes suivantes :
a1. Mise à disposition d'un tube interne (5) ayant une section transversale (36) et une surface périphérique extérieure (37),
a2. Enduction d'au moins une partie (38) de la surface périphérique extérieure (37) avec
i) un diélectrique (39) et
ii) un matériau de piste conductrice (40) pour produire des pistes conductrices (19),
a3. Application d'un matériau semiconducteur (41) ou d'au moins un élément thermoélectrique (7) ;
et en plus
b1. Mise à disposition d'un tube externe (6) ayant une surface intérieure (42),
b2. Application sur au moins une partie (38) de la surface intérieure (42)
i) d'un diélectrique (39) et
ii) d'un matériau de piste conductrice (40) pour produire des pistes conductrices (19),
et en plus
c1. Assemblage du tube externe (6) et du tube interne (5), procédé selon lequel, à l'étape b. ii), le matériau de piste conductrice (40) sous la forme d'un tube profilé interne (47) ayant un diamètre intérieur (43) minimal est inséré dans le tube externe (6) et relié avec celui-ci et, selon une étape supplémentaire b3., le diamètre intérieur (43) minimal est élargi.

9. Procédé selon la revendication 8, selon lequel le module (1) présente une première extrémité (3) et une deuxième extrémité (4) et les pistes conductrices électriques (19) à la première extrémité (3) et à la deuxième extrémité (4) sont reliées de manière électriquement conductrice au moins à chaque fois avec un contact électrique (8, 18).

10. Procédé de fabrication d'un module (1), comprenant au moins les étapes suivantes :
a1. Mise à disposition d'un tube interne (5) ayant une section transversale (36) et une surface périphérique extérieure (37),
a2. Enduction d'au moins une partie (38) de la surface périphérique extérieure (37) avec
i) un diélectrique (39) et
ii) un matériau de piste conductrice (40) pour produire des pistes conductrices (19),
a3. Application d'un matériau semiconducteur (41) ou d'au moins un élément thermoélectrique (7) ;
et en plus
b1. Mise à disposition d'un tube externe (6) ayant une surface intérieure (42),
b2. Application sur au moins une partie (38) de la surface intérieure (42)
i) d'un diélectrique (39) et
ii) d'un matériau de piste conductrice (40) pour produire des pistes conductrices (19),
et en plus
c1. Assemblage du tube externe (6) et du tube interne (5), procédé selon lequel le matériau semiconducteur (41) appliqué sur la surface périphérique (37) du tube interne (5), après l'étape a3., est dopé dans une étape a4. pour former au moins un élément thermoélectrique (7).
